# EUROPÄISCHE PATENTSCHRIFT

(11) **EP 1 344 437 B1**
(45) Veröffentlichungstag und Bekanntmachung des Hinweises auf die Patenterteilung: **04.08.2004**
(21) Anmeldenummer: 01271036.4
(22) Anmeldetag: 30.11.2001
(51) Int. Cl.: H05K 7/14, G01N 33/00

(54) **MODUL FÜR MESSZWECKE**
MODULE FOR MEASURING PURPOSES
MODULE DE MESURE

(30) Priorität: 12.12.2000 DE 10061854
(43) Veröffentlichungstag der Anmeldung: 17.09.2003
(73) Patentinhaber: Testo AG, 79849 Lenzkirch (DE)
(72) Erfinder: DERR, Andreas, 79793 Wutöschingen (DE); STREICHER, Manfred, 79853 Lenzkirch (DE); SCHULZ, Peter, 79843 Löffingen (DE)
(74) Vertreter: Patentanwälte Westphal, Mussgnug & Partner
(86) Internationale Anmeldenummer: PCT/EP2001/014031
(87) Internationale Veröffentlichungsnummer: WO 2002/049408

(56) Entgegenhaltungen:
- EP-A- 0 890 836
- EP-A- 0 924 810
- US-A- 4 956 747
- US-A- 5 864 467
- US-A- 6 137 686

## Beschreibung

Die Erfindung betrifft ein Modul für Meßzwecke gemäß dem Oberbegriff des Anspruchs 1.

Aus dem Stand der Technik sind Gehäuse oder Aufnahmeboxen bekannt, in die eine begrenzte Anzahl von sogenannten Einschubkarten einschiebbar sind. Unter Fachleuten sind diese Systeme unter dem Namen 19 -Racks öder dergleichen bekannt.

Ein modul gemäß dem Oberbegriff von Anspruch 1 wird in US-A-6 137 686 gezeigt.

Derartige modulartig aufgebaute,Einschubkarten, vorzugsweise eine elektrische oder elektronische Schaltungsanordnung tragende Platinen, weisen in der Regel einen oder mehrere Energie versorgungsanschlüsse und einen oder mehrere Datenleitungsanschlüsse auf, welche durch das Einschieben der Einschubkarten in eine oben bezeichnete Aufnahmebox in eine an der Rückseite der entsprechenden Aufnahmebox angebrachte Steckeinrichtung eingesteckt werden.

Alle an der Rückseite einer Aufnahmebox angeordneten Steckeinrichtungen sind in der Regel gleichartig aufgebaut und die entsprechenden Kontakte der einzelnen Steckplätze sind mittels einer elektrischen Verbindung miteinander verbunden. Auf diese Weise wird erreicht, dass die in die Aufnahmebox eingeschobenen Einschubkarten in der Art eines Busses miteinander verschaltet sind.

Obwohl sich ein derartiges System bewährt hat, liegt der inhärente Nachteil darin, dass die Aufnahmebox nur eine begrenzte Anzahl von Einschubkarten aufnehmen kann. Ein derartiges System ist daher nicht frei skalierbar, sondern stets durch die Baugröße der entsprechenden Aufnahmebox begrenzt. Zudem eignet sich ein derartiges System aufgrund seiner fest vorgegebenen Baugröße nur bedingt für die sogenannte portable Meßtechnik.

Der Erfindung liegt somit die Aufgabe zugrunde, ein System vorzustellen, welches die oben genannten Nachteile nicht mehr aufweist. Insbesondere soll ein System vorgestellt werden, welches in beliebiger Weise frei skalierbar ist und nicht durch die Baugröße einer Aufnahmebox begrenzt ist. Zudem soll ein Einsatz an nahezu jedem beliebigen Ort möglich sein. Schließlich soll ein Einsatz sowohl für sehr einfache als auch für aufwendige Meßzwecke möglich sein.

Diese Aufgabe wird durch ein Modul für Meßzwecke mit den Merkmalen des, kennzeichnenden Teils des Anspruchs 1 erfindungsgemäß gelöst.

Vorteilhafte Ausführungen und Weiterbildungen der Erfindung sind in den Unteransprüchen angegeben.

Der wesentliche Gedanke der Erfindung besteht darin, dass die elektronische Schaltungsanordnung in einem Gehäuse angeordnet ist, welches eine erste Anlagefläche und eine zweite Anlagefläche aufweist. Erfindungsgemäß ist dabei vorgesehen, dass die erste Anlagefläche mit der zweiten Anlagefläche eines weiteren gleichartig ausgebildeten Moduls mechanisch lösbar verbindbar, d.h. zusammenfügbar, verrastbar, verschnappbar oder dergleichen, ist. Dabei ist vorgesehen, dass zumindestens ein Energieversorgungsanschluß jeweils einen Energieversorgungskontakt in der ersten Anlagefläche und einen korrespondierenden Energieversorgungskontakt in der zweiten Anlagefläche aufweist und dass der zumindestens eine Datenleitungsanschluß jeweils einen Datenleitungskontakt in der ersten Anlagefläche und einen korrespondierenden Datenleitungskontakt in der zweiten Anlagefläche aufweist. Konkret bedeutet dies, dass die entsprechenden Energieversorgungskontakte bzw. Datenleitungskontakte von der ersten Anlagefläche zur zweiten Anlagefläche durchgeschleift sind.

Es ist nunmehr vorgesehen, dass im verbundenen Zustand, d.h. wenn die zweite Anlagefläche des weiteren Moduls mit der ersten Anlagefläche in der oben beschriebenen Weise zusammengefügt ist, der Energieversorgungskontakt in der ersten Anlagefläche mit dem korrespondierenden Energieversorgungskontakt in der zweiten Anlagefläche des weiteren Moduls und entsprechend der Datenleitungskontakt der ersten Anlagefläche mit dem korrespondierenden Datenleitungskontakt in der zweiten Anlagefläche des weiteren Moduls in elektrisch leitender Verbindung ist.

Eine Verbindung zwischen einzelnen Modulen (entsprechend den Einschubkarten in dem System gemäß dem Stand der Technik) erfolgt demzufolge unmittelbar durch Kontaktierung der in den jeweiligen Gehäusen der Module angebrachten Kontakten und nicht wie bei dem System gemäß dem Stand der Technik mit Hilfe zusätzlicher Verbindungen, welche beispielsweise Bestandteil einer Aufnahmebox sind oder gegebenenfalls mit Hilfe separater Kabel oder Leitungen herzustellen sind.

Auf diese Weise wird ermöglicht, dass beispielsweise mit Hilfe eines einzigen Moduls einfache Meßaufgaben durchgeführt werden können und je nach Erfordernis weitere Module nach dem Lego-Prinzip zu einer größeren Meßeinheit verbunden werden können. Ferner ergibt sich dadurch die Möglichkeit, aus einem Modulsortiment für nahezu beliebige Meßaufgaben passende Module zusammenzustellen. Das Meßsystem kann auf diese Weise schnell an nahezu jedem beliebigen Ort auf- und wieder abgebaut werden. Es ist sowohl ein Transport einzelner Module möglich als auch ein Transport eines größeren verbundenen Gesamtsystems. Ferner ist die Gefahr, einer Zerstörung oder Verschmutzung der eigentlichen elektrischen oder elektronischen Schaltungsanordnung deutlich gegenüber dem oben genannten System gemäß dem Stand der Technik reduziert.

Eine bevorzugte Ausführungsform der Erfindung sieht vor, dass zum Zusammenfügen des Moduls mit dem weiteren Modul ein bajonettartiger Verschluß vorgesehen ist. Der Vorteil eines derartigen bajonettartigen Verschlusses besteht darin, dass ein Verschließen und Lösen der Verbindung zum einen schnell, zum anderen auf einfache Weise erfolgen kann. Derartige bajonettartige Verschlüsse haben sich in vielfacher Weise bewährt.

In einer besonders vorteilhaften Variante ist vorgesehen, dass die ersten und zweiten Anlageflächen im Wesentlichen parallel zueinander angeordnete-gegenüberliegende Gehäuseflächen sind. Eine Meßeinheit ergibt sich in der Weise, dass mehrere oder eine Vielzahl derartiger Module übereinander gestapelt werden. Somit ergibt sich eine besonders kompakte Meßanordnung.

Hierbei ist insbesondere vorteilhaft, wenn die ersten und zweiten Anlageflächen die Stand- und Deckelflächen sind, so dass sich die zu der Position eines derartigen Systems notwendige Standfläche mit zunehmender Anzahl der verwendeten Einzelmodule nicht erhöht.

Eine besonders vorteilhafte Variante sieht vor, dass das Gehäuse im Wesentlichen quaderförmig ausgebildet ist, eine Gehäuseform welche sich durch ihren geringen Platzbedarf auszeichnet.

Erfindungsgemäß ist vorgesehen, dass auf der ersten Anlagefläche zumindestens zwei im Wesentlichen parallel zueinander verlaufende Führungsschienen angebracht sind, an deren der Anlagefläche abgewandten Seite im Wesentlichen parallel zur Anlagefläche verlaufende Haltestege angeformt sind und auf der zweiten Anlagefläche zu den Führungsschienen der ersten Anlagefläche korrespondierende im Wesentlichen parallel zueinander verlaufende Führungsschienen angebracht sind, an deren der Anlagefläche abgewandten Seite im Wesentlichen parallel zur Anlagefläche verlaufende zu den Haltestegen der Führungsschienen der ersten Anlagefläche korrespondierende Haltestege angeformt sind, so dass die Haltestege mit den korrespondierenden Haltestegen eines weiteren Moduls in übergreifende Verbindung verbringbar sind und die Module auf diese Weise zusammenhalten. Eine derartige Anordnung hat zum Einen den Vorteil einer einfachen Herstellbarkeit beispielsweise mit Hilfe eines Spritzgießverfahrens, zum Anderen ermöglicht sie eine sichere und schnelle Verbindung zwischen einzelnen Modulen, welche sich ebenso schnell und sicher wieder lösen läßt.

Eine Ausgestaltung dieser Variante sieht vor, dass die Haltestege und die korrespondierenden Haltestege derart beabstandet sind, dass zum Zusammenfügen der ersten Anlagefläche mit der zweiten Anlagefläche des weiteren Moduls die Haltestege in die Beabstandung der korrespondiereden Haltestege der zweiten Anlagefläche des weiteren Moduls eingreifbar sind und umgekehrt die korrespondierenden Haltestege der zweiten Anlagefläche des weiteren Moduls in die Beabstandung der Haltestege eingreifbar sind und in dieser Stellung durch Verschieben der jeweiligen Module gegeneinander die Haltestege mit den korrespondierenden Haltestegen des weiteren Moduls in übergreifende, die Module zusammenhaltende Verbindung verbringbar sind.

In einer Weiterführung dieser Variante oder in von dieser Variante unabhängiger selbständiger Ausgestaltung des erfindungsgemäßen Moduls ist vorgesehen, dass ein Kipphebel an einem an der Seitenfläche des Gehäuses angeordneten Kipplager kippbar gelagert ist. Ein Hebelarm des Kipphebels ist dabei gegen die Kraft einer Feder an der Seitenfläche des Gehäuses des Moduls abgestützt. Der andere Hebelarm des Kipphebels weist eine Rastnase auf, welche in eine Nut des Gehäuses des weiteren Moduls eingreifbar und mit dieser verrastbar ist. Ein derartiger Kipphebel verriegelt somit zwei zusammengesteckte Module miteinander, so dass sie nicht unbeabsichtigt voneinander getrennt werden können.

In einfacher Weise läßt sich der Verrast- und Verriegelungsmechanismus des Kipphebels dadurch realisieren, dass die Rastnase in eine von der Führungsschiene und dem Haltesteg gebildete Nut eingreift. Zusätzliche Maßnahmen sind demnach bei dieser Variante nicht erforderlich.

Erfindungsgemäß ist fernerhin vorgesehen, dass zumindest ein Kontakt der ersten Anlagefläche ein in eine Ausformung der ersten Anlagefläche eingesetzter Kontaktkopf mit einer Kontaktfläche ist. Korrespondierend hierzu ist der korrespondierende Kontakt der zweiten Anlagefläche ein im Wesentlichen senkrecht zur Anlagefläche gegen die Kraft einer Feder verschieblich geführter Kontaktstößel. Auf diese Weise läßt sich einfach und schnell eine elektrisch leitende Verbindung zwischen zwei zusammengesteckte und gegebenenfalls verrasteten Modulen herstellen. Die federnde Verschieblichkeit des Kontaktstößels hat darüberhinaus den Vorteil, dass auch nach häufigen Zusammensteck -Vorgängen ein sicherer elektrischer Kontakt herstellbar ist, insbesondere auch dann, wenn die entsprechenden Kontaktstellen durch häufige Benutzung äbgetragen sind oder gar verschmutzt oder korrodiert sind.

Eine besonders vorteilhafte Variante der Erfindung sieht vor, dass zur Herstellung der elektrischen Verbindung zwischen dem Kontaktkopf und dem Kontaktstößel innerhalb des Gehäuses eines Moduls ein Federblech vorgesehen ist, welches sich einendseitig federnd gegen eine ins Gehäuseinnere gerichtete Kontaktspitze des Kontaktkopfs abstützt und andernendseitig gegen einen ins Gehäuseinnere gerichtete Kontaktfläche des Kontaktstößels. Eine derartige federnde Kontaktierung hat zum Einen den Vorteil gegenüber einer starren Kontaktierung, dass bei Erschütterungen ein Brechen bzw. Abbrechen der elektrischen Kontaktierung weitgehend vermieden wird, zum Anderen ergibt sich dadurch der Vorteil einer einfachen Montage eines Moduls ohne zeitintensive Löt- oder Befestigungsvorgänge.

Erfindungsgemäß ist fernerhin vorgesehen, dass die SchaltungsAnordnung auf einer Platine angeordnet ist und dass das Federblech mit der Platine mechanisch starr und elektrisch leitend verbunden ist. Diese Ausführungsvariante der Erfindung hat den Vorteil, dass für das Federblech keine zusätzliche Halterung erforderlich ist, da eine Fixierung in der Platine innerhalb des Gehäuses des Moduls ohnehin erforderlich ist. Die Platine hält somit das Federblech fest, so dass beispielsweise die die Anlageflächen bildenden Deckel- bzw. Bodenplatten bei der Fertigung oder Montage lediglich aufgesetzt zu werden brauchen.

Eine weitere Variante der Erfindung sieht vor, dass der Kontaktstößel in einem Führungselement verschieblich geführt ist. In dieses Führungselement ist ein Dichtelement eingesetzt, welches den Kontaktstößel in der oben beschriebenen Art und Weise verschieblich umschließt und welches an deren inneren den Kontaktstößel umschließenden Umfang eine Dichtlippe zum Abdichten aufweist. Auf diese Weise wird verhindert, dass Wasser oder andere Flüssigkeiten in das Gehäuseinnere gelangen und die elektrische oder elektronische Schaltungsanordnung bzw. einzelne elektrische oder elektronische Schaltungselemente zerstört werden.

Eine weitere bevorzugte Ausführungsvariante sieht vor, dass die Kontaktfläche des Kontaktkopfs von zwei im Wesentlichen parallel zu den Führungsschienen ausgerichteten Stegen eingeschlossen ist, welche derart über die Kontaktfläche des Kontaktkopfs überstehen, dass ein Berühren derselben durch einen genormten Meßfinger ausgeschlossen ist. Eine derartige Ausgestaltung der Erfindung dient als Schutzvorrichtung gegen elektrostatische Entladungen.

In entsprechender Weise ist vorgesehen, dass die Kontaktspitze des Kontaktstößels aus dem Grund einer in der Anlagefläche eingeformten im Wesentlichen parallel zu den Führungsschienen verlaufenden Nut herausgeführt ist und dass die Breite der Nut so gewählt ist, dass ein Berühren der Kontaktspitze des Kontaktstößels durch einen genormten Meßfinger ausgeschlossen ist. Die beiden letztgenannten Varianten stellen somit sicher, dass die in dem Modul angeordnete elektrische oder elektronischen Schaltungsanordnungen bzw. einzelne Schaltungselemente durch Aufladungen der bedienenden Personen keinen Schaden nehmen.

Es sind Module mit folgenden Funktionen vorgesehen:
a) Meßwertaufnahmemodule
b) Energieversorgungsmodule
c) Funkverbindungsmodule zum Herstellen einer Funkverbindung zwischen aus einem oder mehreren Modulen aufgebauten Meßsystemen oder Meßeinheiten
d) Analog-Digitalumsetzmodule bzw. ein Digital-Analogumsetzmodule
e) Module mit Bedien- und Anzeigefunktionen
f) Module mit Druckfunktionen
g) Rauchgasmeldemodule

Ein Ausführungsbeispiel der Erfindung ist in der Zeichnung dargestellt und wird im folgenden näher beschrieben.

Es zeigen:
- Fig. 1: eine Meßeinheit bestehend aus einem erfindungsgemäßen Bedien-, Meß-, Anzeige- und Druckmodul und zwei erfindungsgemäßen Meßmodulen
- perspektivische Ansicht von oben -
- Fig.2: eine Meßeinheit bestehend aus einem erfindungsgemäßen Funkmodul und zwei erfindungsgemäßen Meßmodulen
- perspektivische Ansicht von oben -
- Fig. 3: ein erfindungsgemäßes Meßmodul gemäß der Fig. 1 und der Fig. 2
- perspektivische Ansicht von unten -
- Fig. 4: die Meßeinheit gemäß der Fig. 2 bestehend aus erfindungsgemäßem Funkmodul und zwei erfindungsgemäßen Meßmodulen
- Querschnittsdarstellung entlang der Ebene A-A -
- Fig. 5: die Meßeinheit gemäß der Fig. 2 und der Fig. 4
- Detailansicht im Längsschnitt entlang B-B -
a) Erfindungsgemäßes Funkmodul und erfindungsgemäßes Meßmodul im aufgesetzten aber nicht verrasteten Zustand
b) Erfindungsgemäßes Funkmodul und erfindungsgemäßes Meßmodul gemäß Fig. 5a) im verrasteten Zustand
- Fig. 6: die Meßeinheit gemäß der Fig. 2 und der Fig. 4 mit Schutzvorrichtung gegen elektrostatische Entladungen
- Detailansicht Z aus der Fig. 4 -
- Fig. 7: die Meßeinheit gemäß der Fig. 2 und der Fig.4:
Verriegelungsmechanismus mit in eine Führungsschiene eines erfindungsgemäßen Meßmoduls eingreifender Rastnase eines Kipphebels
   - Detailansicht Y aus der Fig. 4 -

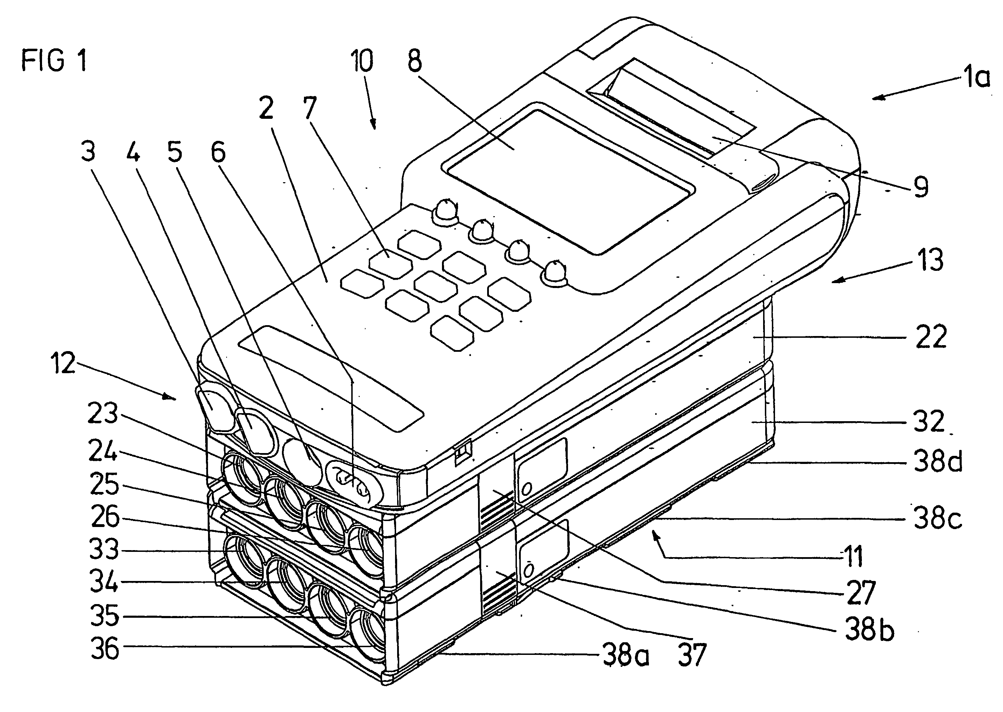

In der Fig. 1 ist eine Meßeinheit 1a bestehend aus mehreren erfindungsgemäßen Einzelmodulen 2, 22, 32 dargestellt. Konkret weist die in der Fig. 1 dargestellte Meßeinheit 1a ein kombiniertes Bedien-, Meß-, Anzeige- und Druckmodul 2, ein mit diesem verbundenes Meßmodul 22 und ein wiederum daran anschließendes weiteres Meßmodul, 32 auf.

Das Bedien-, Meß-, Anzeige- und Druckmodul 2 weist wie die Namensgebung bereits nahelegt, eine Tastatur 7 zur Dateneingabe und damit Bedienen des Moduls 2, einen Meßkanalanschluß 5 zum Verbinden mit einer Meßzelle; einem Meßwertaufnehmer, einem Sensor oder dergleichen auf. Ferner ist ein Display 8 vorgesehen, um die dem Meßkanalanschluß 5 zugeführten Meßwerte zur Anzeige zu bringen sowie einen Kleindrucker 9, um beispielsweise ein Meß- oder Datenprotokoll zu erstellen. Fernerhin weist das Bedien-, Meß-, Anzeige- und Druckmodul 2 ein Sendeelement 3 und ein Empfangselement 4 auf, über welche eine Datenkommunikation beispielsweise via Funk, Infrarot oder dergleichen zu einem weiteren Modul aufgebaut werden kann. Schließlich weist das Bedien-, Meß-, Anzeige- und Druckmodul an dessen Vorderseite 12 auch noch einen Energieversorgungsanschluß 6 auf, um das Modul 2 von außen mit Energie versorgen zu können. Im vorliegenden Beispiel erfolgt die Energieversorgung via einen Netzstecker an einem herkömmlichen Niederspannungsnetzanschluß, es ist jedoch auch denkbar, das Modul 2 netzautark oder über einen integrierten Akkumulator, Batterien oder dergleichen zu betreiben.

Die beiden ebenfalls in der Fig. 1 dargestellten weiteren Meßmodule 22 und 32 sind im Vergleich zueinander in weitgehend identischer Form ausgeführt. Beide weisen an deren Vorderseite 12 in die Frantflächen-94 eingearbeitet jeweils vier Meßkanalanschlüsse 23, 24, 25 und 26 sowie 33, 34, 35 und 36 auf. Diese Meßkanalanschlüsse 23, 24, 25, 26 bzw. 33, 34, 35, 36 sind in der Art des Meßkanalanschlusses 5 der Bedien-, Meß-, Anzeige- und Druckmoduls 2 ausgeführt. Sie stellen somit lediglich eine Erweiterung zum Anschluß weiterer acht Meßwertaufnehmer, Sensoren oder dergleichen dar.

Erfindungsgemäß ist vorgesehen, dass die Bedienung, Parametrierung und Ansteuerung der weiteren Meßkanalanschlüsse 23, 24, 25 und 26 des Meßmoduls 22 sowie der Meßkanalanschlüsse 33, 34, 35 und 36 des Meßmoduls 32 über das Bedien-, Meß-, Anzeige- und Druckmodul 2 erfolgt. Auch die Auswertung, Datenerfassung, Protokollierung etc. erfolgt via das Bedien-, Meß-, Anzeige- und Druckmodul 2, welches wie nachfolgend beschrieben wird mit den Einzelmodulen 22 und 32 sowohl mechanisch als auch elektrisch verbunden ist.

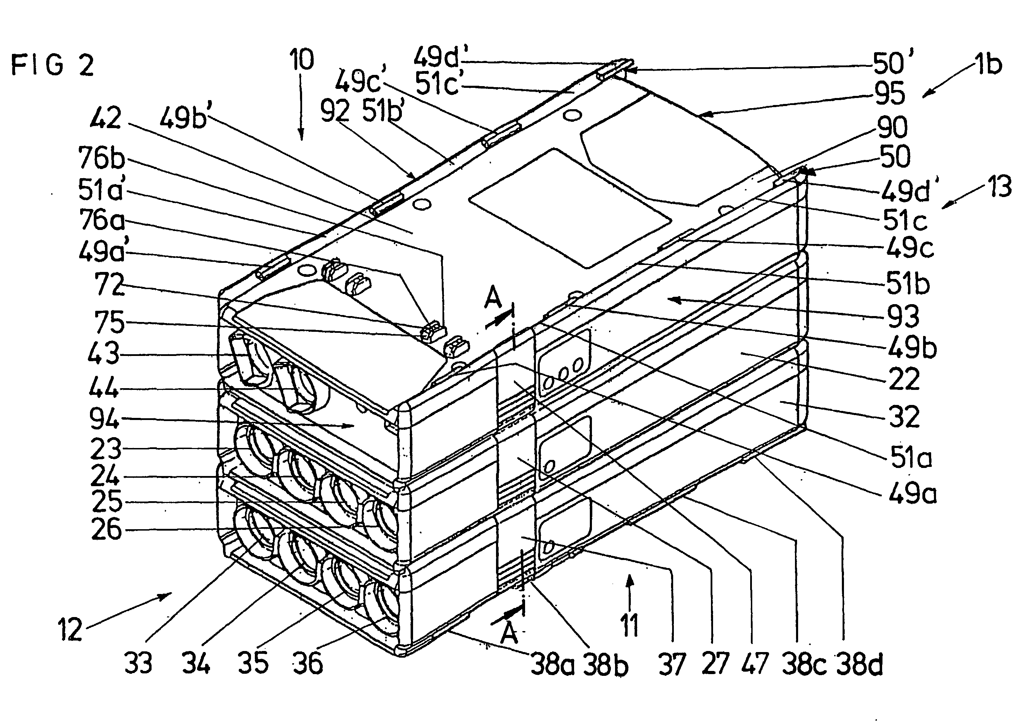

Zur Demonstration wie eine derartige mechanische und elektrische Verbindung zwischen den einzelnen Modulen gemäß der Erfindung realisiert ist, zeigen die Figuren 2 bis 7 Einzelheiten des mechanischen Verrast- bzw. Verriegelungsmechanismusses sowie der zur Herstellung einer elektronischen Verbindung zwischen den Einzelmodulen notwendigen korrespondierenden Kontaktelemente.

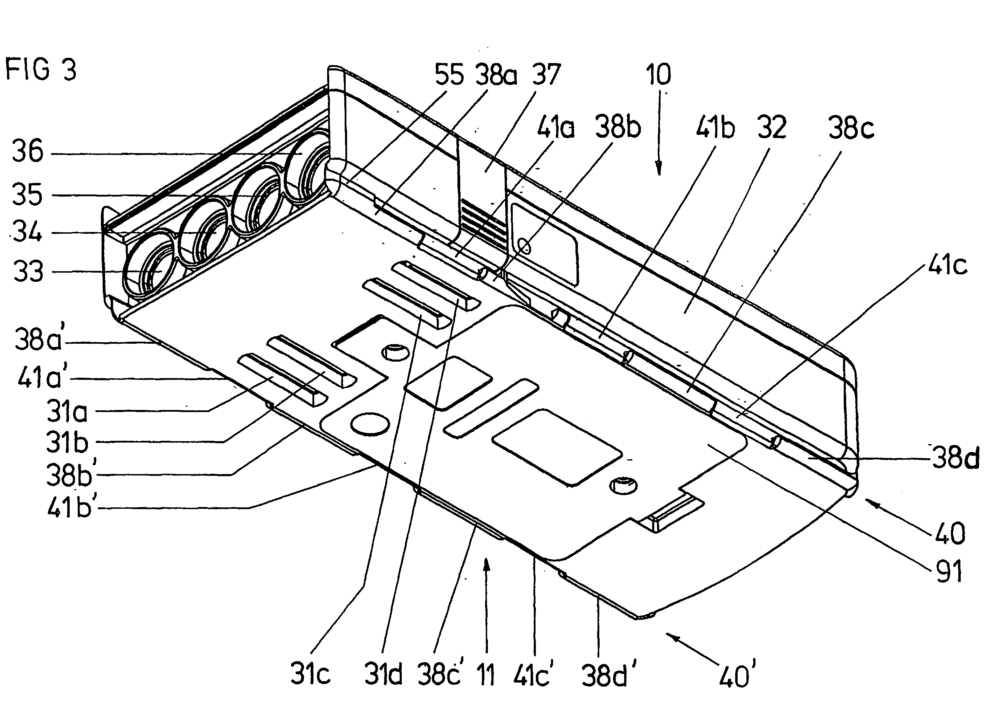

Die Fig. 2 zeigt zunächst eine erfindungsgemäße Meßeinheit 1b bestehend aus zwei erfindungsgemäßen Meßmodulen 22 und 32 der vorgehend beschriebenen Art sowie anstelle des in der Fig. 1 dargestellten Bedien-, Meß-, Anzeige- und Druckmoduls 2 ein erfindungsgemässes Funkmodul 42 und zwar in perspektivischer Ansicht von oben auf die Oberseite 10 des Funkmoduls 42. Korrespondierend hierzu zeigt die Fig. 3 exemplarisch das erfindungsgemäße Meßmodul 32 gemäß den Figuren 1 und 2 ebenfalls in perspektivischer Ansicht jedoch von unten mit Blickrichtung auf dessen Unterseite 11.

Das Gehäuse der dargestellten Module 22, 32, 42 ist im Wesentlichen quaderförmig ausgebildet. Es besteht demzufolge aus sechs Einzelflächen, welche im Folgenden als Seitenflächen 92 und 93, Frontfläche 94, Rückseitenfläche 95 sowie erste Anlagefläche 90 und zweite Anlagefläche 91 bezeichnet sind. Die ersten und zweiten Anlageflächen 90, 91 sind die gegenüberliegend angeordneten Stand- bzw. Deckelflächen. Die jeweiligen Frontflächen (und gegebenenfalls auch die Rückseitenfläche 95) weisen wie oben bereits beschrieben, Meßkanalanschlüsse 23, 24, 25, 26 bzw. 33, 34, 35, 36 sowie Sendeelemente 43 und 44 auf.

Die erste Anlagefläche 90 eines Moduls 22, 32, 42 ist mit der zweiten Anlagefläche 91 eines weiteren Moduls 22, 32, 42 verrastbar. Der Verrastmechanismus ist im Beispiel in der Art eines Bajonettverschlusses ausgeführt. Konkret sind auf der ersten Anlagefläche 90 zwei im Wesentlichen parallel zueinander verlaufende Führungsschienen 50 und 50' angebracht, an deren der Anlagefläche 90 abgewandten Seite im Wesentlichen parallel zur Anlagefläche 90 verlaufende Haltestege 49a, 49b, 49c, 49d, 49a',49b', 49c', 49d' angeformt sind. Auf der jeweiligen zweiten Anlagefläche 79 sind zu den Führungsschienen 50, 50' der ersten Anlagefläche 90 korrespondierend im Wesentlichen ebenfalls parallel zueinander verlaufende Führungsschienen 40, '40' angebracht. An diesen Führungsschienen 40, 40' sind an deren der Anlagefläche 91 abgewandten Seite im Wesentlichen parallel zur Anlagefläche verlaufende zu den Haltestegen 49a, 49b, 49c, 49d, 49a', 49b',49c', 49d' der Führungsschienen 50, 50' der ersten Anlagenfläche 90 korrespondierende Haltestege 38a, 38b, 38c, 38d, 38a', 38b', 38c', 38d' angeformt. Während im ersten Falle die Haltestege 49a, 49b, 49c, 49d, 49a', 49b', 49c', 49d' nach innen gegeneinander weisen, sind im zweiten Fall die Haltestege 38a, 38b, 38c, 38d, 38a', 38b', 38c', 38d' nach außen gerichtet verlaufend, so dass die Haltestege 49a, 49b, 49c, 49d, 49a', 49b', 49c', 49d' mit den korrespondierenden Haltestegen 38a, 38b, 38c, 38d, 38a', 38b', 38c', 38d' des weiteren Moduls in übergreifende Verbindung verbringbar sind und auf diese Weise zwei benachbarte Module 42 und 22 bzw. 22 und 32 zusammengehalten werden.

Im vorliegenden Beispiel sind die Haltestege 49a, 49b, 49c, 49d, 49a', 49b', 49c', 49d' und die korrespondierenden Haltestege 38a, 38b, 38c, 38d, 38a', 38b', 38c', 38d' derart beabstandet, dass zum Zusammenfügen der ersten Anlagefläche 90 eines Moduls 22, 42 mit der zweiten Anlagefläche 91 des benachbarten Moduls 32, 22 die Haltestege 49a, 49b, 49c, 49d, 49a', 49b', 49c', 49d' in die Beabstandung 41a, 41b, 41c, 41a', 41b', 41c' der korrespondierenden Haltestege 38a, 38b, 38c, 38d, 38a', 38b', 38c', 38d' der zweiten Anlagefläche 91 des benachbarten Moduls eingreifen können. In analoger Weise können dabei die korrespondierenden Haltestege 38a, 38b, 38c, 38d, 38a', 38b', 38c', 38d' der zweiten Anlagefläche 91 des weiteren Moduls in die Beabstandung 51a, 51b, 51c, 51a', 51b', 51c' der Haltestege 49a, 49b, 49c, 49d, 49a', 49b', 49c', 49d' eingreifen. In die Festhaltestellung, d.h. die die beiden benachbarten Module 42 und 22 bzw. 22 und 32 zusammenhaltende Verbindung, werden die jeweiligen Module 22, 32, 42 dadurch gebracht, dass sie in dieser oben bezeichneten Stellung gegeneinander verschoben werden, so dass die Haltestege 49a, 49b, 49c, 49d, 49a', 49b', 49c', 49d' mit den korrespondierenden Haltestegen 38a, 38b, 38c, 38d, 38a', 38b', 38c', 38d' des benachbarten Moduls 22, 32, 42 einander übergreifen.

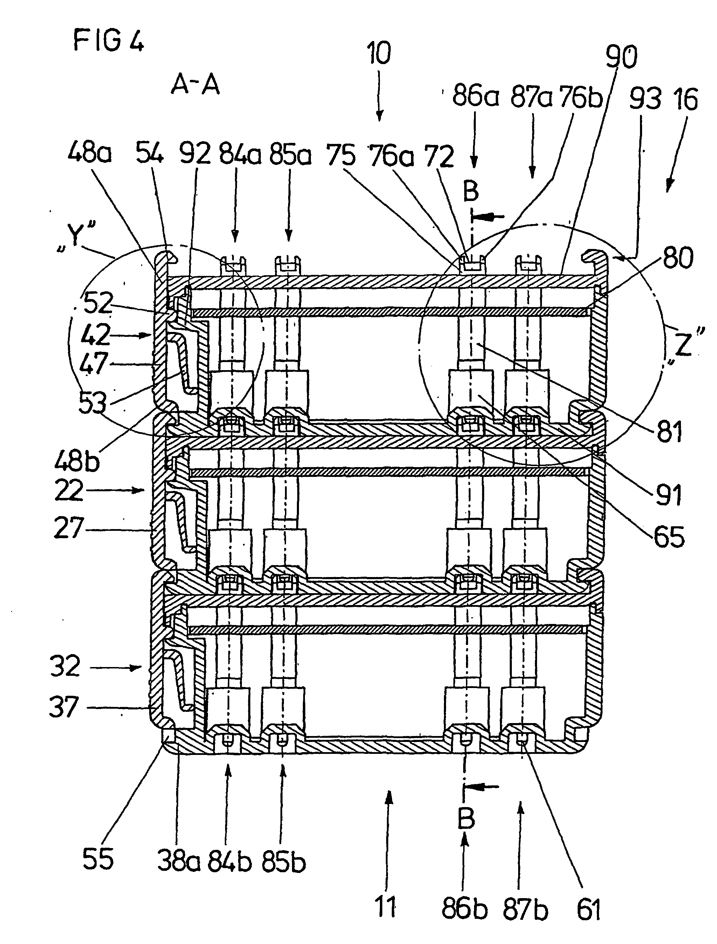

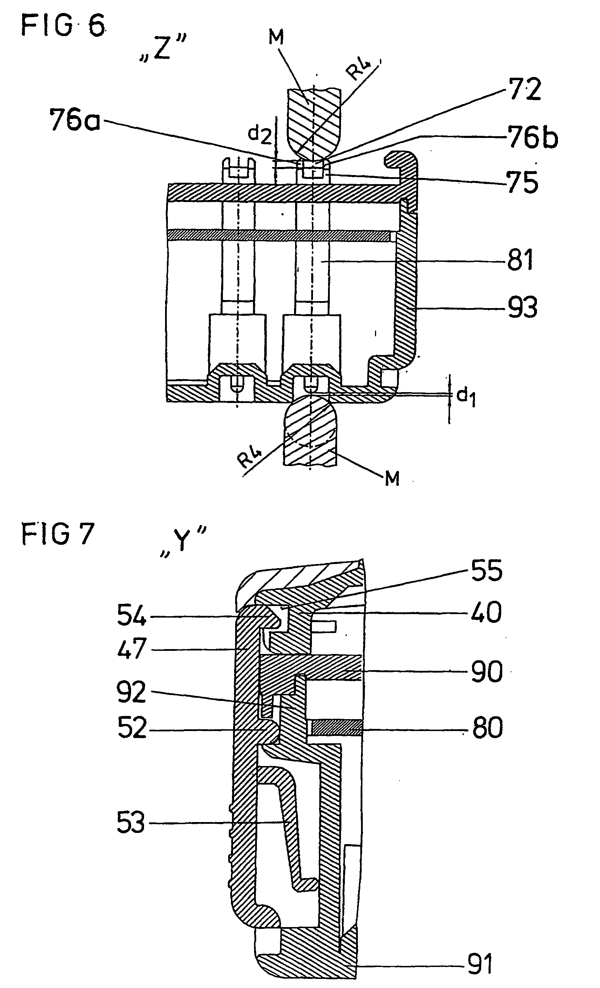

Erfindungsgemäß ist ferner vorgesehen, dass zwei benachbarte Module 42 und 22 bzw. 22 und 32 mit Hilfe eines Kipphebels 27, 37, 47 verriegelt werden können. Die besondere erfindungsgemäße Ausgestaltung eines derartigen Verriegelungsmechanismusses entnimmt man im Detail den Figuren 4, welche die Meßeinheit gemäß der Fig. 2, bestehend aus erfindungsgemäßem Funkmodul 42 und zwei erfindungsgemäßen Meßmodulen 22 und 32 in Querschittsdarstellung entlang der in der Fig. 2 angedeuteten Ebene A-A zeigt und der in der Fig. 7 dargestellten Detailansicht Y aus der Fig. 4.

Wie aus den Zeichnungen zu entnehmen ist, ist der Kipphebel 27, 37, 47 an einem an der Seitenfläche 92 des jeweiligen Gehäuses angeordneten Kipplager 52 kippbar gelagert. Ein Hebelarm 48b des Kipphebels-27, 37, 47 ist gegen die Kraft einer Feder 53 an der Seitenfläche 92 des jeweiligen Gehäuses abgestützt. In der Zeichnung ist die Feder 53 in der Art eines Federblechs ausgeführt, eine Federung beispielsweise mit Hilfe einer Spiralfeder oder dergleichen ist in gleicher Weise denkbar.

Der andere Hebelarm 48a des Kipphebels 27, 37, 47 weist eine Rastnase 54 auf, welche in eine Nut 55 des Gehäuses des benachbarten Moduls eingreifbar und mit dieser verrastbar ist.

Im vorliegenden Fall wird die Nut durch die Führungsschiene 40 und den Haltesteg 38b gebildet.

Wie in der Beschreibungseinleitung bereits eingehend dargelegt wurde, sind die einzelnen Module 22, 32, 42 über elektrische Kontaktstellen, die sich im geschachtelten Zustand berühren, leitend miteinander verbunden. Insbesondere sind im vorliegenden Fall zwei Energieversorgungskontakte 84a, 85a vorgesehen, welche in der ersten Anlagefläche 90 eines Moduls 22, 32, 42 angeordnet sind und mit dem korrespondierenden Energieversorgungskontakt 84b, 85b in der zweiten Anlagefläche 91 des weiteren benachbarten Moduls 22, 32, 42 in Verbindung verbringbar sind. Desweiteren sind in der ersten Anlagefläche 90 eines Moduls 22, 32, 42 Datenleitungskontakte 86a, 87a vorgesehen, welche mit den korrespondierenden Datenleitungskontakten 86b, 87b in der zweiten Anlagefläche 91 des weiteren benachbarten Moduls 22, 32, 42 in Verbindung verbringbar sind.

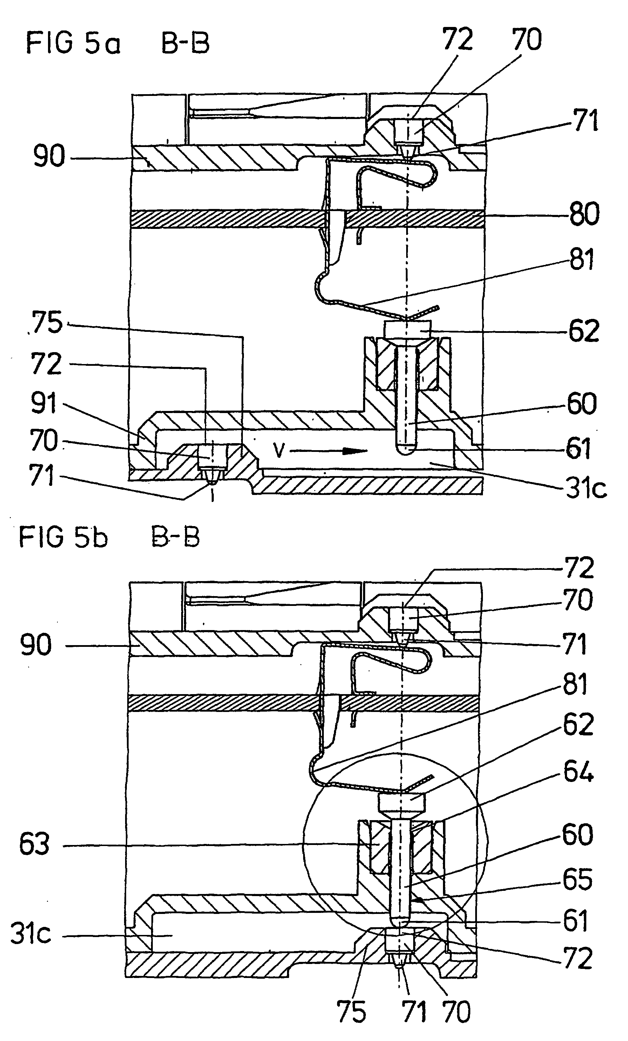

Die konkrete Ausführung der Kontakte 84a, 85a, 86a, 87a in der ersten Anlagefläche 90 und der korrespondierenden Kontakte 84a', 85a', 86a', 87a' der zweiten Anlagefläche 91 entnimmt man den Zeichnungen gemäß der Fig. 2, der Fig. 3, der Fig. 4 und der Fig. 6. Die elektrische und mechanische Verbindung zwischen den Kontakten 84a, 85a, 86a und 87a in der ersten Anlagefläche 90 und den korrespondierenden Kontakten 84a', 85a', 86a', 87a' der zweiten Anlagefläche 91 innerhalb eines Moduls entnimmt man insbesondere den Fig. 4, 5a und 5b.

Wie sich insbesondere aus der Fig. 5 ergibt, bestehen die Kontakte 84a, 85a, 86a, 87a der ersten Anlagefläche 90 jeweils aus einem in eine Ausformung 75 der ersten Anlagefläche 90 eingesetzten Kontaktkopf 70, welcher jeweils eine Kontaktfläche 72 aufweist. Die korrespondierenden Kontakte 84a', 85a', 86a', 87a' der zweiten Anlagefläche 91 sind im Wesentlichen senkrecht zu Anlagefläche 91 gegen die Kraft einer Feder 81 verschieblich geführte Kontaktstößel 60.

Die Kontaktflächen 72 der jeweiligen Kontaktköpfe 70 sind jeweils von zwei im Wesentlichen parallel zu den Führungsschienen 50, 50' ausgerichteten Stegen 76a und 76b eingeschlossen. Diese stehen derart über die Kontaktflächen 72 der jeweiligen Kontaktköpfe 70 über, so dass, wie insbesondere aus der Fig. 6 zu entnehmen ist, ein Berühren derselben durch einen genormten Meßfinger M ausgeschlossen ist. Im vorliegenden Fall ist der Abstand zwischen der Spitze des genormten Meßfingers M mit. Spitzenradius 4mm von einer Kontaktfläche 72 mit Hilfe des Bezugszeichens d₂ gekennzeichnet.

In prinzipiell ähnlicher Weise sind auch die anderen Kontakte 84b, 85b, 86b, 87b mit Kontaktstößel 60 ausgeführt. Wie in der Fig. 6 dargestellt ist, sind die jeweiligen Kontaktstößel 60 aus dem Grund einer in der Anlagefläche 91 eingeformten im Wesentlichen parallel zu den Führungsschienen 40, 40' verlaufenden Nuten 31a, 31b, 31c, 31d herausgeführt, wobei die Breite der entsprechenden Nuten 31a, 31b, 31c, 31d so gewählt ist, dass ein Berühren der jeweiligen Kontaktspitzen 61 der Kontaktstößel 60 durch den genormten Meßfinger M mit Spitzenradius 4mm ausgeschlossen ist. Der Abstand zwischen der Kontaktspitze 61 eines Kontaktstößels 60 und einem genormten Meßfinger M ist in der Zeichnung mit dem Bezugszeichen d₁ gekennzeichnet.

Wie insbesondere den Zeichnungen gemäß der Fig. 4 und den Figuren 5a und 5b zu entnehmen ist, sind die Stege 76a, 76b, welche die Kontaktflächen 72 der jeweiligen Kontaktköpfe 70 einschließen gerade so ausgebildet, dass sie zum Zusammenfügen zweier Module 22, 32, 42 gerade in die jeweiligen Nuten 31a, 31b, 31c, 31d aus deren Grund die jeweiligen Kontaktstößel 60 herausgeführt sind, eingreifen. Die elektrische Verbindung wird nunmehr dadurch hergestellt, dass beim oben bezeichneten Verschiebevorgang V die entsprechenden Kontakte 84a, 85a, 86a, 87a mit den korrespondierenden Kontakten 84a', 85a', 86a', 87a' in Verbindung verbracht werden. Dabei wird die Kontaktspitze 61 des Kontaktstößels 60 gegen die Kraft der Feder 81 über die Ausformung 75 und den darin eingesetzten Kontaktkopf 70 mit der Kontaktfläche 72 geführt, wobei die Stege 76a und 76b als Führungsschienen, für die Kontaktspitze 61 des Kontaktstößels 60 dienen.

Die federnd verschiebliche Führung des Kontaktstößels 60 und die Herstellung der elektrischen Verbindung zwischen den jeweiligen Kontakten 84a, 84b, 85a, 86a, 86b, 87a, 87b innerhalb eines Gehäuses ist wie nachfolgend beschrieben wird mit Hilfe eines Federblechs 81 realisiert. So ist zwischen dem Kontaktkopf 70 und dem Kontaktstößel 60 ein Federblech 81 derart angeordnet, dass es sich einendseitig federnd gegen eine ins Gehäuseinnere gerichtete Kontaktspitze 71 des Kontaktkopfs 70 abstützt und andernendseitig gegen eine ins Gehäuseinnere gerichtete Kontaktfläche 62 des Kontaktstößels 60. Eine mechanische Fixierung des Federblechs 81 ist dadurch realisiert, dass es mit einer die Schaltungsanordnung tragenden Platine 80 mechanisch starr und elektrisch leitend verbunden ist.

### Bezugszeichenliste

- 1a: Meßeinheit
- 1b: Meßeinheit
- 2: Bedien-, Meß-, Anzeige- und Druckmodul
- 3: Sendeelement
- 4: Empfangselement
- 5: Meßkanalanschluß
- 6: Energieversorgungsanschluß
- 7: Tastatur
- 8: Display
- 9: Drucker
- 10: Oberseite
- 11: Unterseite
- 12: Vorderseite
- 13: Rückseite

- 22: Meßmodul
- 23: Meßkanalanschluß
- 24: Meßkanalanschluß
- 25: Meßkanalanschluß
- 26: Meßkanalanschluß
- 27: Kipphebel
- 31a: Nut
- 31b: Nut
- 31c: Nut
- 31d: Nut

- 32: Meßmodul
- 33: Meßkanalanschluß
- 34: Meßkanalanschluß
- 35: Meßkanalanschluß
- 36: Meßkanalanschluß
- 37: Kipphebel
- 38a: Haltesteg
- 38b: Haltesteg
- 38c: Haltesteg
- 38d: Haltesteg
- 38a': Haltesteg

- 38b': Haltesteg
- 38c': Haltesteg
- 38d': Haltesteg
- 40: Führungsschiene
- 40': Führungsschiene
- 41a: Beabstandung
- 41b: Beabstandung
- 41c: Beabstandung

- 42: Funkmodul
- 43: Sendeelement
- 44: Empfangselement
- 47: Kipphebel
- 48a: Hebelarm
- 48b: Hebelarm
- 49a: Haltesteg
- 49b: Haltesteg
- 49c: Haltesteg
- 49d: Haltesteg
- 49a': Haltesteg
- 49b': Haltesteg
- 49c': Haltesteg
- 49d': Haltesteg
- 50: Führungsschiene
- 50': Führungsschiene
- 51a: Beabstandung
- 51b: Beabstandung
- 51c: Beabstandung
- 52: Kipplager
- 53: Feder
- 54: Rastnase
- 55: Nut

- 60: Kontaktstößel
- 61: Kontaktspitze
- 62: Kontaktfläche
- 63: Dichtelement
- 64: Dichtlippe
- 65: Führungselement

- 70: Kontaktkopf
- 71: Kontaktspitze
- 72: Kontaktfläche
- 75: Ausformung
- 76a: Steg
- 76b: Steg

- 80: Platine
- 81: Federblech

- 84a: Kontakt
- 84b: Kontakt
- 85a: Kontakt
- 85b: Kontakt
- 86a: Kontakt
- 86b: Kontakt
- 87a: Kontakt
- 87b: Kontakt

- 90: erste Anlagefläche
- 91: zweite Anlagefläche
- 92: Seitenfläche
- 93: Seitenfläche
- 94: Frontfläche
- 95: Rückseitenfläche

- V: Verschieberichtung
- d₁: Abstand
- d₂: Abstand
- M: genormter Meßfinger

## Patentansprüche

1. Modul für Meßzwecke
- mit einer elektrischen oder elektronischen Schaltungsanordnung, welche
- zumindestens einen Energieversorgungsanschluß und
- zumindestens einen Datenleitungsanschluß zum Verbinden mit mindestens einem weiteren Modul gleicher Art in der Art eines Busses aufweist, wobei
- die elektronische Schaltungsanordnung (80) in einem Gehäuse angeordnet ist, wobei
- das Gehäuse eine erste Anlagefläche (90) und eine zweite Anlagefläche (91) aufweist, wobei
- die erste Anlagefläche (90) mit der zweiten Anlagefläche (91) des weiteren Moduls (22, 32, 42), mechanisch lösbar verbindbar ist, wobei
- der zumindestens eine Energieversorgungsanschluß jeweils einen Energieversorgungskontakt (84a, 85a) in der ersten Anlagefläche (90) und einen korrespondierenden Energieversorgungskontakt (84b, 85b) in der zweiten Anlagefläche (91) aufweist und
- der zumindestens eine Datenleitungsanschluß jeweils einen Datenleitungskontakt (86a, 87a) in der ersten Anlagefläche (90) und einen korrespondierenden Datenleitungskontakt (86b, 87b) in der zweiten Anlagefläche (91) aufweist, wobei
- im verbundenen Zustand der Energieversorgungskontakt (84a, 85a) in der ersten Anlagefläche (90) mit dem korrespondierenden Energieversorgungskontakt (84b, 85b) in der zweiten Anlagefläche (91) des weiteren Moduls (22, 32, 42) und
- der Datenleitungskontakt (86a, 87a) der' ersten Anlagefläche (90) mit dem korrespondierenden Datenleitungskontakt (86b, 87b) in der zweiten Anlagefläche (91) des weiteren Moduls (22, 32, 42) in elektrisch leitender Verbindung sind, **dadurch gekennzeichnet, daß** zumindestens ein Kontakt (84a, 85a, 86a, 87a) der ersten Anlagefläche (90) ein in ein Ausformung (75) der ersten Anlagefläche (90) eingesetzter Kontaktkopf (70) mit einer Kontaktfläche (72) ist und der korrespondierende Kontakt (84b', 85b', 86b', 87b') der zweiten Anlagefläche (91) ein im Wesentlichen senkrecht zur Anlagefläche (91) gegen die Kraft einer Feder (81) verschieblich geführter Kontaktstößel (60) ist.

2. Modul nach Anspruch 1,
**dadurch gekennzeichnet, dass**
zum Zusammenfügen des Moduls (22, 32, 42) mit dem weiteren Modul (22, 32, 42) ein bajonettartiger Verschluß vorgesehen ist.

3. Modul nach Anspruch 1 oder 2,
**dadurch gekennzeichnet, dass**
die ersten und zweiten Anlageflächen (90, 91) im Wesentlichen parallel zueinander angeordnete, gegenüberliegende Gehäuseflächen sind.

4. Modul nach einem der Ansprüche 1 bis 3,
**dadurch gekennzeichnet, dass**
die ersten und zweiten Anlageflächen (90, 91) die Standund Deckelflächen sind.

5. Modul nach einem der Ansprüche 1 bis 4,
**dadurch gekennzeichnet, dass**
das Gehäuse im Wesentlichen quaderförmig ausgebildet ist.

6. Modul nach einem der vorangegangenen Ansprüche,
**dadurch gekennzeichnet, dass**
auf der ersten Anlagefläche (90) zumindestens zwei im Wesentlichen parallel zueinander verlaufende Führungsschienen (50, 50') angebracht sind, an deren der Anlagefläche (90) abgewandten Seite im Wesentlichen parallel zur Anlagefläche (90) verlaufende Haltestege (49a, 49b, 49c, 49d, 49a', 49b', 49c', 49d') angeformt sind und
auf der zweiten Anlagefläche (91) zu den Führungsschiehen (50, 50') der ersten Anlagefläche (90) korrespondierende im Wesentlichen parallel zueinander verlaufende Führungsschienen (40, 40') angebracht sind, an deren der Anlagefläche (91) abgewandten Seite im Wesentlichen parallel zur Anlagefläche (91) verlaufende zu den Haltestegen (49a, 49b, 49c, 49d, 49a', 49b', 49c', 49d') der Führungsschienen (50, 50') der ersten Anlagefläche (90) korrespondierende Haltestege (38a, 38b, 38c, 38d, 38a', 38b', 38c', 38d') angeformt sind, so dass die Haltestege (49a, 49b, 49c, 49d, 49a',49b', 49c', 49d') mit den korrespondierenden Haltestegen (38a, 38b, 38c, 38d, 38a', 38b', 38c', 38d') des weiteren Moduls (22, 32, 42) in übergreifende Verbindung verbringbar sind und die Module (22, 32, 42) zusammenhalten.

7. Modul nach Anspruch 6,
**dadurch gekennzeichnet, dass**
die Haltestege (49a, 49b, 49c, 49d, 49a', 49b', 49c', 49d') und die korrespondierenden Haltestege (38a, 38b, 38c, 38d, 38a', 38b', 38c', 38d') derart beabstandet sind, dass zum Zusammenfügen der ersten Anlagefläche (90) mit der zweiten Anlagefläche (91) des weiteren Moduls (22, 32, 42) die Haltestege (49a, 49b, 49c, 49d, 49a', 49b', 49c', 49d') in die Beabstandung (41a, 41b, 41c, 41a', 41b', 41c') der korrespondierenden Haltestege (38a, 38b, 38c, 38d, 38a', 38b', 38c', 38d') der zweiten Anlagefläche (91) des weiteren Moduls (22, 32, 42) eingreifbar sind und die
korrespondierende Haltestege (38a, 38b, 38c, 38d, 38a', 38b', 38c', 38d') der zweiten Anlagefläche (91) des weiteren Moduls in die Beabstandung (51a, 51b, 51c, 51a', 51b', 51c') der Haltestege (49a, 49b, 49c, 49d, 49a', 49b', 49c', 49d') eingreifbar sind
und in dieser Stellung durch Verschieben der jeweiligen Module (22, 32, 42) gegeneinander die Haltestege (49a, 49b, 49c, 49d, 49a', 49b', 49c', 49d') mit den korrespondierenden Haltestegen (38a, 38b, 38c, 38d, 38a', 38b', 38c', 38d') des weiteren Moduls (22, 32, 42) in übergreifende, die Module (22, 32, 42) zusammenhaltende Verbindung verbringbar sind.

8. Modul nach einem der vorangegangenen Ansprüche,
**dadurch gekennzeichnet, dass**
zumindestens ein Kipphebel (27, 37, 47) vorgesehen ist, welcher an einem an der Seitenfläche (92) des Gehäuses angeordneten Kipplager (52) kippbar gelagert ist, wobei ein Hebelarm (48b) des Kipphebels (27, 37, 47) gegen die Kraft einer Feder (53) an der Seitenfläche (92) abgestützt ist und der andere Hebelarm (48a) des Kipphebels (27, 37 47) eine Rastnase (54) aufweist, welche in eine Nut (55) des Gehäuses des weiteren'Moduls eingreifbar und mit dieser verrastbar ist.

9. Modul nach Anspruch 8,
**dadurch gekennzeichnet, dass**
die Rastnase (54) in eine von der Führungsschiene (40) und dem Haltesteg (38b) gebildete Nut (55) eingreift.

10. Modul nach einem der vorangegangenen Ansprüche,
**dadurch gekennzeichnet, dass**
zur Herstellung der elektrischen Verbindung zwischen dem Kontaktkopf (70) und dem Kontaktstößel (60) innerhalb des Gehäuses ein Federblech (81) vorgesehen ist, welches sich einendseitig federnd gegen eine ins Gehäuseinnere gerichtete Kontaktspitze (71) des Kontaktkopfs (70) abstützt und andernendseitig gegen eine ins Gehäuseinnere gerichtete Kontaktfläche (62) des Kontaktstößels (60) abstützt.

11. Modul nach Anspruch 10,
**dadurch gekennzeichnet, dass**
die Schaltungsanordnung auf einer Platine (80) angeordnet ist und dass das Federblech (81) mit der Platine (80) mechanisch starr und elektrisch leitend verbunden ist.

12. Modul nach einem der vorangegangenen Ansprüche,
**dadurch gekennzeichnet, dass**
der Kontaktstößel (60) in ein Führungselement (65) verschieblich geführt ist, in welches ein Dichtelement (63) eingesetzt ist, welches den Kontaktstößel (60) verschieblich umschließt und welches an deren inneren den Kontaktstößel (60) umschließenden Umfang eine Dichtlippe (64) zum Abdichten aufweist.

13. Modul nach einem der vorangegangenen Ansprüche,
**dadurch gekennzeichnet, dass**
die Kontaktfläche (72) des Kontaktkopfs (70) von zwei im Wesentlichen parallel zu den Führungsschienen (50, 50') ausgerichteten Stegen (76a, 76b) eingeschlossen ist, welche derart über die Kontaktfläche (72) des Kontaktkopfs (70) überstehen, dass ein Berühren derselben durch einen genormten Meßfinger (M) ausgeschlossen ist.

14. Modul nach einem der vorangegangenen Ansprüche,
**dadurch gekennzeichnet, dass**
die Kontaktspitze (61) des Kohtaktstößels (60) aus dem Grund einer in der Anlagefläche (91) eingeformten im Wesentlichen parallel zu den Führungsschienen (40, 40') verlaufenden Nut (31a, 31b, 31c, 31d) herausgeführt ist und dass die Breite der Nut (31a, 31b, 31c, 31d) so gewählt ist, dass ein Berühren der Kontaktspitze (61) des Kontaktstößels (60) durch einen genormten Meßfinger (M) ausgeschlossen ist.

15. Modul nach einem der vorangegangenen Ansprüche,
**dadurch gekennzeichnet, dass**
die Schaltungsanordnung zur Meßwertaufnahme vorgesehen (2, 22, 32) ist.

16. Modul nach einem der vorangegangenen Ansprüche,
**dadurch gekennzeichnet, dass**
die Schaltungsanordnung zu einer Energieversorgung vorgesehen ist.

17. Modul nach einem der vorangegangenen Ansprüche,
**dadurch gekennzeichnet, dass**
die Schaltungsanordnung zu einer Herstellung einer Funkverbindung (42) vorgesehen ist.

18. Modul nach einem der vorangegangenen Ansprüche,
**dadurch gekennzeichnet, dass**
die Schaltungsanordnung zu einer Analog-Digital Umsetzung vorgesehen ist.

19. Modul nach einem der vorangegangenen Ansprüche,
**dadurch gekennzeichnet, dass**
die Schaltungsanordnung zu einer Erzeugung von Bedien- und Anzeigefunktionen vorgesehen ist.

20. Modul nach einem der vorangegangenen Ansprüche,
**dadurch gekennzeichnet, dass**
die Schaltungsanordnung zu einer Erzeugung von Druckfunktionen vorgesehen ist.

21. Modul nach einem der vorangegangenen Ansprüche,
**dadurch gekennzeichnet, dass**
die Schaltungsanordnung zu einer Rauchgasanalyse vorgesehen ist.

22. Modul nach einem der vorangegangenen Ansprüche,
**dadurch gekennzeichnet, dass**
der Datenleitungsanschluß ein CAN-Bus-Anschluß ist.

## Claims

1. Module for measuring purposes
- having an electrical or electronic circuit arrangement, which has
- at least one power supply connection, and
- at least one data line connection for connecting to at least one further module of the same type in the manner of a bus, in which
- the electronic circuit arrangement (80) is arranged in a housing, in which
- the housing has a first bearing surface (90) and a second bearing surface (91), in which
- the first bearing surface (90) can be mechanically and releasably connected to the second bearing surface (91) of the further module (22, 32, 42),
in which
- each of the at least one power supply connections has a power supply contact (84a, 85a) in the first bearing surface (90) and a corresponding power supply contact (84b, 85b) in the second bearing surface (91), and
- each of the at least one data line connections has a data line contact (86a, 87a) in the first bearing surface (90) and a corresponding data line contact (86b, 87b) in the second bearing surface (91), in which
- when connected, the power supply contact (84a, 85a) in the first bearing surface (90) is electrically conductively connected to the corresponding power supply contact (84b, 85b) in the second bearing surface (91) of the further module (22, 32, 42), and
- the data line contact (86a, 87a) in the first bearing surface (90) is electrically conductively connected to the corresponding data line contact (86b, 87b) in the second bearing surface (91) of the further module (22, 32, 42), **characterized in that** at least one contact (84a, 85a, 86a, 87a) of the first bearing surface (90) is a contact head (70), which is inserted in a shaped part (75) of the first bearing surface (90), having a contact surface (72), and the corresponding contact (84b', 85b', 86b', 87b') of the second bearing surface (91) is a contact plunger (60), which is guided essentially perpendicular to the bearing surface (91) such that it can move counter to the force of a spring (81).

2. Module according to Claim 1, **characterized in that** a bayonet-type fastening is provided for the purpose of joining the module (22, 32, 42) and the further module (22, 32, 42) together.

3. Module according to Claim 1 or 2, **characterized in that** the first and second bearing surfaces (90, 91) are opposing housing surfaces which are arranged essentially parallel to one another.

4. Module according to one of Claims 1 to 3, **characterized in that** the first and second bearing surfaces (90, 91) are the base and top surfaces.

5. Module according to one of Claims 1 to 4, **characterized in that** the housing is essentially in the form of a square.

6. Module according to one of the preceding claims, **characterized in that** provided on the first bearing surface (90) are at least two guide rails (50, 50'), which extend essentially parallel to one another, and have integrally formed on their side facing away from the bearing surface (90) retaining webs (49a, 49b, 49c, 49d, 49a', 49b', 49c', 49d'), which extend essentially parallel to the bearing surface (90), and
provided on the second bearing surface (91) are guide rails (40, 40'), which correspond to the guide rails (50, 50') of the first bearing surface (90), extend essentially parallel to one another and have integrally formed on their side facing away from the bearing surface (91) retaining webs (38a, 38b, 38c, 38d, 38a', 38b', 38c', 38d'), which extend essentially parallel to the bearing surface (91) and correspond to the retaining webs (49a, 49b, 49c, 49d, 49a', 49b', 49c', 49d') of the guide rails (50, 50') of the first bearing surface (90), so that the retaining webs (49a, 49b, 49c, 49d, 49a', 49b', 49c', 49d') can be brought into contact with the corresponding retaining webs (38a, 38b, 38c, 38d, 38a', 38b', 38c', 38d') of the further module (22, 32, 42) such that they overlap one another, and so that the modules (22, 32, 42) are held together.

7. Module according to Claim 6, **characterized in that** the retaining webs (49a, 49b, 49c, 49d, 49a', 49b', 49c', 49d') and the corresponding retaining webs (38a, 38b, 38c, 38d, 38a', 38b', 38c', 38d') are spaced apart from one another such that, for the purpose of joining the first bearing surface (90) and the second bearing surface (91) of the further module (22, 32, 42) together, the retaining webs (49a, 49b, 49c, 49d, 49a', 49b', 49c', 49d') can engage in the spacing (41a, 41b, 41c, 41a', 41b', 41c') between the corresponding retaining webs (38a, 38b, 38c, 38d, 38a', 38b', 38c', 38d') of the second bearing surface (91) of the further module (22, 32, 42), and
the corresponding retaining webs (38a, 38b, 38c, 38d, 38a', 38b', 38c', 38d') of the second bearing surface (91) of the further module can engage in the spacing (51a, 51b, 51c, 51a', 51b', 51c') between the retaining webs (49a, 49b, 49c, 49d, 49a', 49b', 49c', 49d'),
and in this position, by displacing the respective modules (22, 32, 42) with respect to one another, the retaining webs (49a, 49b, 49c, 49d, 49a', 49b', 49c', 49d') can be brought into contact with the corresponding retaining webs (38a, 38b, 38c, 38d, 38a', 38b', 38c', 38d') of the further module (22, 32, 42) such that they overlap one another and such that the modules (22, 32, 42) are held together.

8. Module according to one of the preceding claims, **characterized in that** at least one toggle lever (27, 37, 47) is provided, which is mounted on a toggle bearing (52), which is arranged on the lateral surface (92) of the housing, such that it can toggle, in which a lever arm (48b) of the toggle lever (27, 37, 47) is supported on the lateral surface (92) counter to the force of a spring (53), and the other lever arm (48a) of the toggle lever (27, 37, 47) has a latching lug (54), which can engage in a groove (55) in the housing of the further module and can latch therewith.

9. Module according to Claim 8, **characterized in that** the latching lug (54) engages in a groove (55) formed by the guide rail (40) and the retaining web (38b).

10. Module according to one of the preceding claims, **characterized in that**, for the purpose of producing the electrical connection between the contact head (70) and the contact plunger (60), a sheet-metal spring (81) is provided within the housing and is supported at one end in a sprung manner against a contact tip (71), which points into the housing interior, of the contact head (70) and is supported at the other end against a contact surface (62), which points into the housing interior, of the contact plunger (60).

11. Module according to Claim 10, **characterized in that** the circuit arrangement is arranged on a printed circuit board (80), and **in that** the sheet-metal spring (81) is connected mechanically rigidly and electrically conductively to the printed circuit board (80).

12. Module according to one of the preceding claims, **characterized in that** the contact plunger (60) is guided in a guide element (65) such that it can be displaced, into which there is inserted a sealing element (63) which surrounds the contact plunger (60) such that it can be displaced and which has, on its inner circumference surrounding the contact plunger (60), a sealing lip (64) for sealing purposes.

13. Module according to one of the preceding claims, **characterized in that** the contact surface (72) of the contact head (70) is enclosed by two webs (76a, 76b), which are aligned essentially parallel to the guide rails (50, 50'), and which protrude beyond the contact surface (72) of the contact head (70) in such a way that it is impossible for a standard measuring finger (M) to come into contact with it.

14. Module according to one of the preceding claims, **characterized in that** the contact tip (61) of the contact plunger (60) is led out of the base of a groove (31a, 31b, 31c, 31d), which is formed in the bearing surface (91), and which extends essentially parallel to the guide rails (40, 40'), and **in that** the width of the groove (31a, 31b, 31c, 31d) is selected such that it is impossible for a standard measuring finger (M) to come into contact with the contact tip (61) of the contact plunger (60).

15. Module according to one of the preceding claims, **characterized in that** the circuit arrangement is provided for the purpose of sensing measured values (2, 22, 32).

16. Module according to one of the preceding claims, **characterized in that** the circuit arrangement is provided for the purpose of supplying power.

17. Module according to one of the preceding claims, **characterized in that** the circuit arrangement is provided for the purpose of producing a wireless link (42).

18. Module according to one of the preceding claims, **characterized in that** the circuit arrangement is provided for analogue/digital conversion.

19. Module according to one the preceding claims, **characterized in that** the circuit arrangement is provided for the purpose of performing operating and display functions.

20. Module according to one of the preceding claims, **characterized in that** the circuit arrangement is provided for the purpose of performing pressure functions.

21. Module according to one of the preceding claims, **characterized in that** the circuit arrangement is provided for the purpose of analysing flue gas.

22. Module according to one of the preceding claims, **characterized in that** the data line connection is a CAN bus connection.

## Revendications

1. Module de mesure, dans lequel :
- un système de circuit électrique ou électronique comporte au moins un raccord d'alimentation en énergie et au moins un raccord de conducteur de données pour liaison avec au moins un autre module du même genre à la manière d'un bus,
- le système de circuit électronique (80) est monté dans un boîtier qui présente une première portée d'appui (90) et une seconde portée d'appui (91), la première portée d'appui (90) pouvant être reliée mécaniquement de manière séparable à la seconde portée d'appui (91) de l'autre module (22, 32, 42),
- le raccord d'alimentation en énergie au nombre d'un au moins présente un contact d'alimentation en énergie (84a, 85a) sur la première portée d'appui (90) et un contact d'alimentation en énergie correspondant (84b, 85b) sur la seconde portée d'appui (91),
- le raccord au conducteur de données au nombre d'un au moins présente un contact de conducteur de données (86a, 87a) sur la première portée d'appui (90) et un contact de conducteur de données correspondant (86b, 87b) sur la seconde portée d'appui (91),
- à l'état relié, le contact d'alimentation en énergie (84a, 85a) situé sur la première portée d'appui (90) est en liaison électrique avec un contact d'alimentation en énergie correspondant (84b, 85b) sur la seconde portée d'appui (91) de l'autre module (22, 32, 42), et le contact de conducteur de données (86a, 87a) de la première portée d'appui (90) est en liaison électrique avec le contact de conducteur de données correspondant (86b, 87b) sur la seconde portée d'appui (91) de l'autre module (22, 32, 42),
**caractérisé en ce que**
au moins un contact (84a, 85a, 86a, 87a) de la première portée d'appui (90) est constitué par une tête de contact (70) qui, insérée dans une saillie (75) de la première portée d'appui (90), présente une portée de contact (72), tandis que le contact correspondant (84b', 85b', 86b' et 87b') de la seconde portée d'appui (91) est constitué par un poussoir de contact (60) qui peut coulisser essentiellement perpendiculairement à la portée d'appui (91), contre l'action d'un ressort (81).

2. Module selon la revendication 1,
**caractérisé en ce que**
pour assembler le module (22, 32, 42) avec l'autre module (22, 32, 42) il est prévu un verrouillage du genre à baïonnette.

3. Module selon la revendication 1 ou 2,
**caractérisé en ce que**
les première et seconde portées d'appui (90, 91) sont constituées par des surfaces du boîtier se faisant face et essentiellement parallèles entre elles.

4. Module selon une des revendications 1 à 3,
**caractérisé en ce que**
les première et seconde portées d'appui (90, 91) sont la surface de l'assise et la surface du couvercle.

5. Module selon une des revendications 1 à 4,
**caractérisé en ce que**
le boîtier a essentiellement la forme d'un parallélépipède.

6. Module selon une des revendications précédentes,
**caractérisé en ce que**
sur la première portée d'appui (90) sont disposés au moins deux rails de guidage (50, 50') essentiellement parallèles, et sur le côté de ces rails éloignés de la portée d'appui (90) sont formées des barrettes de maintien (49a, 49b, 49c, 49d, 49a', 49b', 49c', 49d') essentiellement parallèles à la portée d'appui (90) et sur la seconde portée d'appui (90) sont disposés des rails de guidage (40, 40') parallèles entre eux et correspondant aux rails de guidage (50, 50') de la première portée d'appui (90), et sur le côté de ces rails éloignés de la portée d'appui (91) sont formées des barrettes de maintien (38a, 38b, 38c, 38d, 38a', 38b', 38c', 38d') parallèles à la portée d'appui (91) et correspondant aux barrettes de maintien (49a, 49b, 49c, 49d, 49a', 49b', 49c', 49d') des rails de guidage (50, 50') de la première portée d'appui (90), de sorte que les barrettes de maintien (49a, 49b, 49c, 49d, 49a', 49b', 49c', 49d') peuvent être amenées en prise les unes sur les autres avec les barrettes de maintien correspondantes (38a, 38b, 38c, 38d, 38a', 38b', 38c', 38d') de l'autre module (22, 32, 42) en réunissant ainsi les modules (22, 32, 42).

7. Module selon la revendication 6,
**caractérisé en ce que**
les barrettes de maintien (49a, 49b, 49c, 49d, 49a', 49b', 49c', 49d') et les barrettes de maintien correspondantes (38a, 38b, 38c, 38d, 38a', 38b', 38c', 38d') sont espacées de manière que, pour assembler la première portée d'appui (90) à la seconde portée d'appui (91) de l'autre module (22, 32, 42), les barrettes de maintien (49a, 49b, 49c, 49d, 49a', 49b', 49c', 49d') peuvent être engagées dans les intervalles (41a, 41b, 41c, 41a', 41b', 41c') séparant les barrettes de maintien correspondantes (38a, 38b, 38c, 38d, 38a', 38b', 38c', 38d') de la seconde portée d'appui (91) de l'autre module (22, 32, 42) et les barrettes de maintien correspondantes (38a, 38b, 38c, 38d, 38a', 38b', 38c', 38d') de la seconde portée d'appui (91) de l'autre module peuvent être engagées dans les intervalles (51a, 51b, 51c, 51a', 51b', 51c') séparant les barrettes de maintien (49a, 49b, 49c, 49d, 49a', 49b', 49c', 49d') et dans cette position, en faisant coulisser les modules correspondants (22, 32, 42) l'un par rapport à l'autre, les barrettes de maintien (49a, 49b, 49c, 49d, 49a', 49b', 49c', 49d') peuvent être amenées en liaison, avec prise les unes sur les autres, avec les barrettes de maintien correspondantes (38a, 38b, 38c, 38d, 38a', 38b', 38c', 38d') de l'autre module (22, 32, 42), et ainsi maintenir réunis les modules (22, 32, 42).

8. Module selon une des revendications précédentes,
**caractérisé en ce que**
au moins un levier basculant (27, 37, 47) monté dans un palier de basculement (52) situé sur la face latérale (92) du boîtier, comporte un bras (48b) qui s'appuie sur cette face latérale (92) contre la force d'un ressort (53), et un autre bras (48a) qui présente une dent d'arrêt (54) qui peut venir s'engager et se bloquer dans une rainure (55) du boîtier de l'autre module.

9. Module selon la revendication 8,
**caractérisé en ce que**
la dent d'arrêt (54) est engagée dans une rainure (55) formée par le rail de guidage (40) et la barrette de maintien (38b).

10. Module selon une des revendications précédentes,
**caractérisé en ce que**
pour établir la liaison électrique entre la tête de contact (70) et le poussoir de contact (60), à l'intérieur du boîtier une lame de ressort (81) s'appuie par une extrémité sur une pointe de contact (71), dirigée vers l'intérieur du boîtier et faisant partie de la tête de contact (70), tandis que par son autre extrémité 1a lame s'appuie sur une portée de contact (62), dirigée vers l'intérieur du boîtier et faisant partie du poussoir de contact (60).

11. Module selon la revendication 10,
**caractérisé en ce que**
le système de circuit est monté sur une platine (80) et la lame de ressort (81) est liée mécaniquement de manière rigide à la platine (80) et lui est reliée électriquement.

12. Module selon une des revendications précédentes,
**caractérisé en ce que**
le poussoir de contact (60) peut coulisser dans un élément de guidage (65) dans lequel est inséré un élément d'étanchéité (63) qui entoure, avec possibilité de coulissement, le poussoir de contact (60) et porte sur sa périphérie entourant ce poussoir une lèvre d'étanchéité (64).

13. Module selon une des revendications précédentes,
**caractérisé en ce que**
la portée de contact (72) de la tête de contact (70) est enserrée par deux barrettes (76a, 76b) essentiellement parallèles aux rails de guidage (50, 50') et qui font saillie sur la portée de contact (72) de la tête de contact (70), de manière à exclure tout contact entre cette portée et un doigt de mesure normalisé (M).

14. Module selon une des revendications précédentes,
**caractérisé en ce que**
la pointe de contact (61) du poussoir de contact (60) est issue du fond d'une rainure (31a, 31b, 31c, 31d) réalisée dans la portée d'appui (91) parallèlement aux rails de guidage (40, 40'), la largeur de cette rainure étant choisie de manière à exclure tout contact entre la pointe de contact (61) du poussoir de contact (60) et un doigt de mesure normalisé (M).

15. Module selon une des revendications précédentes,
**caractérisé en ce que**
le système de circuit est prévu pour accueillir des valeurs de mesure.

16. Module selon une des revendications précédentes,
**caractérisé en ce que**
le système de circuit est prévu pour assurer une alimentation d'énergie.

17. Module selon une des revendications précédentes,
**caractérisé en ce que**
le système de circuit est prévu pour établir une liaison radio (42).

18. Module selon une des revendications précédentes,
**caractérisé en ce que**
le système de circuit est prévu pour assurer une conversion analogique-numérique.

19. Module selon une des revendications précédentes,
**caractérisé en ce que**
le système de circuit est prévu pour assurer des fonctions de service et d'indication.

20. Module selon une des revendications précédentes,
**caractérisé en ce que**
le système de circuit est prévu pour assurer des fonctions de pression.

21. Module selon une des revendications précédentes,
**caractérisé en ce que**
le système de circuit est prévu pour réaliser une analyse de gaz de fumée.

22. Module selon une des revendications précédentes,
**caractérisé en ce que**
le raccord de conducteur de données est un raccord de bus CAN.
